# FASCICULE DE BREVET EUROPEEN

(11) **EP 3 671 248 B1**
(45) Date de publication et mention de la délivrance du brevet: **23.03.2022**
(21) Numéro de dépôt: 19218092.5
(22) Date de dépôt: 19.12.2019
(51) Int. Cl.: G01R 33/26

(54) **MAGNÉTOMÈTRE À POMPAGE OPTIQUE D'UN ÉLÉMENT SENSIBLE AVEC UNE LUMIÈRE POLARISÉE LINÉAIREMENT ET MULTI-PASSAGE DANS L'ÉLÉMENT SENSIBLE**
MAGNETOMETER MIT OPTISCHER PUMPFUNKTION EINES SENSIBLEN ELEMENTS MIT EINEM LINEAR POLARISIERTEN LICHT UND MEHRWEG-DURCHGANG IN DEM SENSIBLEN ELEMENT
MAGNETOMETER WITH OPTICAL PUMPING OF A SENSITIVE ELEMENT WITH A LINEARLY POLARISED LIGHT AND MULTI-PASSAGE IN THE SENSITIVE ELEMENT

(30) Priorité: 21.12.2018 FR 1873864
(43) Date de publication de la demande: 24.06.2020
(73) Titulaire: Commissariat à l'énergie atomique et aux énergies alternatives, 75015 Paris (FR)
(72) Inventeur: PALACIOS LALOY, Agustin, 38054 GRENOBLE Cedex 09 (FR); FOURCAULT, William, 38054 GRENOBLE Cedex 09 (FR)
(74) Mandataire: Brevalex

(56) Documents cités:
- EP-A1- 3 364 204
- US-A1- 2007 205 767
- US-B1- 8 212 556
- S. Li ET AL: "Optical rotation in excess of 100 rad generated by Rb vapor in a multipass cell", Physical Review A, vol. 84, no. 6, 1 December 2011 (2011-12-01), XP055165970, ISSN: 1050-2947, DOI: 10.1103/PhysRevA.84.061403
- François Beato ET AL: "parametric-resonance magnetometer based on atomic alignment", Physical Review A, vol. 98, no. 5, 26 November 2018 (2018-11-26), XP055607399, ISSN: 2469-9926, DOI: 10.1103/PhysRevA.98.053431

## Description

### DOMAINE TECHNIQUE

Le domaine de l'invention est celui des magnétomètres à pompage optique, et plus particulièrement celui des magnétomètres à pompage réalisé avec une lumière polarisée linéairement. L'invention trouve application pour l'imagerie des champs biomagnétiques au moyen d'un réseau de magnétomètres, notamment en magnétocardiographie ou en magnétoencéphalographie.

### TECHNIQUE ANTÉRIEURE

Les magnétomètres à pompage optique utilisent un gaz atomique confiné dans une cellule, typiquement de l'hélium métastable ou des gaz d'alcalins, en tant qu'élément sensible. Ces magnétomètres, qui peuvent prendre différentes configurations, permettent de remonter au champ magnétique en exploitant les trois processus suivants qui ont lieu de façon soit séquentielle soit concomitante :
1) L'utilisation de sources de lumière polarisée, typiquement des lasers, permet de préparer des états atomiques caractérisés par une certaine orientation ou alignement de leurs spins. Ce processus reçoit le nom de « pompage optique » dans le domaine.
2) Ces états atomiques évoluent sous l'effet du champ magnétique, notamment sous l'effet Zeeman qui correspond à des décalages des niveaux d'énergie en fonction du champ magnétique auquel sont soumis les atomes.
3) Les propriétés optiques du milieu atomique subissent alors des modifications qui dépendent de l'état des atomes. On peut ainsi par une mesure optique, par exemple par une mesure d'absorption optique, remonter au décalage Zeeman subi et en déduire une mesure du champ magnétique dans lequel est plongée la cellule.

On distingue deux grandes catégories de magnétomètres à pompage optique selon le type de pompage réalisé.

Dans la catégorie la plus répandue, le pompage est réalisé avec un faisceau de pompe émettant une lumière à polarisation circulaire et le gaz atomique acquiert un état dit orienté caractérisé par une valeur moyenne non nulle de son moment magnétique selon un axe, qui se trouve être celui de propagation du faisceau de pompe.

Dans l'autre catégorie, le pompage est réalisé avec un faisceau de pompe émettant une lumière en polarisation linéaire et le gaz atomique acquiert un état dit aligné caractérisé par une valeur nulle de son moment magnétique, mais par une valeur non nulle d'une grandeur du type (3 F_{z}² - F²) où F est le moment cinétique total et Fz le moment cinétique le long de la direction de polarisation du faisceau de pompe.

La caractérisation des états atomiques (étape 3 ci-dessus) peut être réalisée selon au moins deux schémas :
- en mesurant l'absorption du faisceau utilisé pour le pompage ou d'un faisceau dit « sonde » accordé à la transition atomique considérée et de même polarisation que le faisceau utilisé pour le pompage ;
- en utilisant un faisceau dit « sonde » de polarisation linéaire et décalé en longueur d'onde par rapport à la transition atomique considérée. Selon le type de polarisation atomique (orientation ou alignement), ce faisceau subit une modification de sa polarisation (rotation du plan de polarisation dans le cas de l'orientation, création d'une composante polarisée circulairement dans le cas de l'alignement) qui peut être mesurée en séparant deux des états de polarisation du faisceau (les deux polarisations à 45° dans le cas de l'orientation, les deux polarisations circulaires dans le cas de l'alignement) puis en les photo-détectant de manière à identifier l'accroissement d'une des polarisations par rapport à l'autre. On parle alors de mesure polarimétrique.

Dans les deux schémas, il est fréquent que la limite de bruit du magnétomètre provienne du bruit de photons (aussi dénommé *shot-noise* dans la littérature anglo-saxonne) qui résulte de la nature discrète des photons qui sont photo-détectés. Il est donc souhaitable pour améliorer le niveau de bruit du capteur d'augmenter l'impact que les propriétés atomiques ont sur les variations des signaux lumineux qui sont photo-détectés après leur passage dans la cellule. Une possibilité pour cela est d'allonger le chemin optique parcouru par la lumière dans la cellule contenant le gaz atomique. Cependant, étant donné que dans des nombreuses applications la taille du capteur doit être réduite, il est nécessaire d'obtenir ce gain de signal par une autre méthode.

Des travaux réalisés à l'Université de Princeton sur des magnétomètres basés sur l'orientation atomique et divulgués notamment dans l'article « Optical rotation in excess of 100 rad generated by Rb vapor in a multipass cell » de S. Li et al., Phys. Rev. A 84, 061403 (2011), ont démontré la possibilité d'obtenir un tel gain au moyen d'une cavité multi-passage dans laquelle la lumière d'un faisceau de sonde parcourt plusieurs fois le milieu atomique. Cette cavité est une cavité délimitée par deux miroirs paraboliques désaxés, dont l'un présente une ouverture transparente de petite taille en son centre. Un faisceau lumineux légèrement divergent est envoyé par ce trou. Ce faisceau subit une expansion progressive dans la cavité, atteint une taille maximale puis reconverge jusqu'à ressortir par le même trou. Si cette architecture permet de réaliser un nombre important de passages et d'atteindre un gain très significatif de signal à bruit, l'agencement des miroirs est assez complexe à réaliser.

Par ailleurs, comme le faisceau subit une expansion progressive, la première trajectoire de propagation est tellement étroite que les atomes se trouvant dans le volume de celle-ci contribuent de façon beaucoup plus marquée au signal que tous les autres. Des niveaux de bruit nettement moins bons que ceux escomptés sont ainsi obtenus. Une solution pour enrayer le problème consiste à exclure les atomes du volume de cette première trajectoire de propagation, par exemple en ne disposant l'élément sensible que dans une moitié de la cavité multi-passage. Mais dans ce cas, à volume constant de l'élément sensible, il est difficile de pouvoir réduire la taille du magnétomètre.

Comme décrit dans l'article de F. Beato et al. initulé « Theory of a 4He parametric-resonance magnetometer based on atomic alignment, Physical Review A 98, 053431 (2018), les magnétomètres réalisant un pompage en polarisation linéaire présentent des avantages significatifs par rapport aux magnétomètres réalisant un pompage en polarisation circulaire. Ces avantages sont notamment une meilleure résolution sur certains axes de mesure et une sensibilité moindre à des phénomènes indésirables, notamment le phénomène connu comme « light-shift » ou « AC-Stark shift » selon lequel une lumière polarisée circulairement et non parfaitement accordée à une transition atomique se comporte comme un champ magnétique fictif perturbant le comportement des atomes. Ces avantages rendent ces magnétomètres en alignement particulièrement intéressants pour l'imagerie des champs biomagnétiques au moyen d'un réseau de magnétomètres, notamment en magnétocardiographie ou en magnétoencéphalographie. Les documents suivants font partie de l'état de l'art: US8212556, EP3364204 et US2007/205767.

### EXPOSÉ DE L'INVENTION

L'invention vise à accroitre le niveau de signal, et de là le rapport signal-à-bruit, d'un magnétomètre à pompage en polarisation linéaire. Elle propose à cet effet un magnétomètre à pompage optique, comprenant une cellule remplie d'un gaz atomique et un détecteur configuré pour délivrer un signal porteur d'une information relative à un état d'alignement des atomes du gaz atomique dans la cellule. Le magnétomètre comprend une source optique apte à délivrer un unique faisceau de lumière polarisé linéairement faisant à la fois office de pompe et de sonde, un collimateur agencé pour collimater l'unique faisceau de lumière avant qu'il n'éclaire la cellule et un miroir agencé pour réfléchir l'unique faisceau de lumière collimaté après qu'il ait traversé la cellule de sorte que l'unique faisceau de lumière collimaté réalise un multi-passage à travers la cellule en venant éclairer plusieurs fois une même région de la cellule.

Certains aspects préférés mais non limitatifs de ce magnétomètre sont les suivants :
- le miroir fait face au collimateur;
- le miroir est agencé sur une surface de la cellule ;
- le miroir est un miroir plan ;
- il comprend une sonde de mesure qui comporte un compartiment de mesure dans lequel est agencée la cellule et, empilé sur le compartiment de mesure, un compartiment optique dans lequel est agencé le collimateur;
- le compartiment optique dispose d'une entrée optique pour l'unique faisceau de lumière et d'un polariseur linéaire interposé entre l'entrée optique et le collimateur ;
- le comportement optique dispose d'une sortie optique pour l'unique faisceau de lumière après le multi-passage à travers la cellule, la sortie optique étant optiquement couplée au détecteur ;
- le détecteur comprend une photodiode agencée dans le compartiment optique pour photo-détecter l'unique faisceau de lumière après le multi-passage à travers la cellule ;
- un ou plusieurs miroirs auxiliaires sur lesquels l'unique faisceau de lumière collimaté est incident sont agencés dans le compartiment optique pour participer au multi-passage de l'unique faisceau de lumière collimaté à travers la cellule ;
- une direction de polarisation de l'unique faisceau de lumière est invariante lors du multi-passage à travers la cellule.

L'invention porte également sur un dispositif de magnétométrie, par exemple un magnétocardiographe ou en magnétoencéphalographe, qui comprend une pluralité de magnétomètres selon l'invention agencés en réseau.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
La figure 1 représente une sonde de mesure d'un magnétomètre selon un mode de réalisation possible de l'invention ;
La figure 2 représente une configuration optique pouvant être exploitée dans l'invention pour réaliser quatre passages du faisceau de lumière à travers la cellule ;
La figure 3 représente une autre configuration optique pouvant être exploitée dans l'invention pour réaliser quatre passages du faisceau de lumière à travers la cellule ;
La figure 4 représente une configuration optique pouvant être exploitée dans l'invention pour réaliser huit passages du faisceau de lumière à travers la cellule.

### DESCRIPTION DÉTAILLÉE

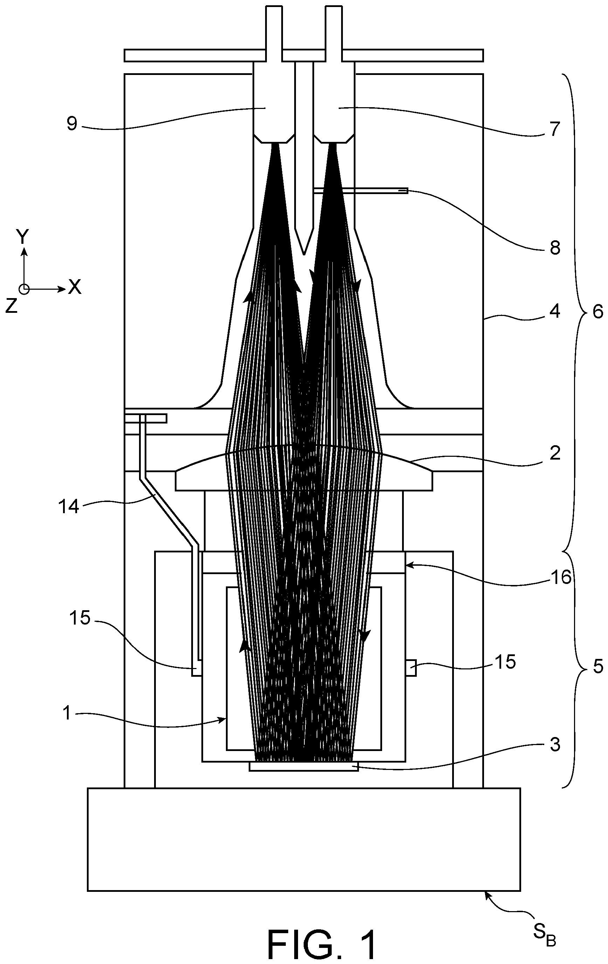

L'invention porte sur un magnétomètre à pompage optique réalisée avec une lumière polarisée linéairement. En référence à la figure 1, le magnétomètre comprend une cellule 1 remplie d'un gaz atomique apte à être polarisé en alignement, par exemple de l'hélium-4 ou un gaz alcalin, et qui est soumis à un champ magnétique ambiant. Le magnétomètre comprend par ailleurs une source optique qui délivre un faisceau de lumière qui va éclairer la cellule et un détecteur qui délivre un signal porteur d'une information relative à l'état d'alignement des atomes du gaz atomique dans la cellule à une électronique de traitement qui exploite ce signal pour fournir une mesure du champ ambiant.

Selon l'invention, le faisceau optique délivré par la source optique remplit à la fois le rôle d'une pompe pour que les atomes du gaz atomique subissent une transition atomique et le rôle d'une sonde car son absorption lors de la traversée de la cellule porte de l'information sur l'état de atomes qui à son tour contient de l'information sur le champ magnétique auquel sont soumis les atomes.

Dans le cadre de l'invention, le faisceau optique est ainsi accordé en longueur d'onde au centre d'une raie de transition atomique, par exemple sur la raie D₀ à 1083 nm dans le cas de l'hélium-4.

Dans un autre mode de réalisation ne faisant pas partie de l'invention, on exploite, d'une part, un faisceau de pompe accordé en longueur d'onde au centre d'une raie de transition atomique et, d'autre part, le faisceau optique délivré par la source optique qui est ici décalé en longueur d'onde par rapport à la transition atomique considérée pour jouer le rôle d'un faisceau de sonde. La mesure réalisée n'est plus alors une mesure d'absorption mais une mesure polarimétrique.

Dans chacun de ces modes de réalisation, le pompage et le sondage sont réalisés avec une lumière polarisée linéairement. On décrit dans ce qui suit en référence à la figure 1 un mode de réalisation de l'invention exploitant un unique faisceau et une mesure d'absorption.

La source optique est typiquement un laser, par exemple une diode semiconductrice. Le faisceau optique délivré par la source optique est polarisé au moyen d'un polariseur rectiligne 8 intercalé entre la source et la cellule 1 ou directement intégré à la source. Le faisceau qui traverse la cellule est ainsi polarisé linéairement, ce qui induit des états atomiques dits « alignés » dans la cellule 1, l'axe d'alignement étant fixé par la direction du champ électrique de la lumière utilisée pour le pompage. Dans ce qui suit, on considère un trièdre de référence XYZ avec l'axe Z aligné sur la direction de polarisation linéaire du faisceau.

Afin d'accroitre le niveau de signal du magnétomètre à pompage en polarisation linéaire, l'invention propose d'augmenter la longueur effective d'interaction entre le gaz atomique sensible située dans la cellule et la lumière du faisceau optique qui est exploité pour mesurer son état d'alignement. L'invention propose plus particulièrement de mettre en œuvre une cavité multi-passage qui ne présente pas les inconvénients de la cavité de l'Université de Princeton et qui est adaptée à un pompage en polarisation linéaire. Ainsi, selon l'invention le magnétomètre comprend un collimateur 2 agencé pour collimater le faisceau de lumière avant qu'il n'éclaire la cellule et un miroir 3 agencé pour réfléchir le faisceau de lumière collimaté après qu'il ait traversé la cellule de sorte que le faisceau de lumière collimaté réalise un multi-passage à travers la cellule en venant éclairer plusieurs fois une même région de la cellule.

Le faisceau de lumière qui réalise ces allers-retours étant collimaté, c'est-à-dire qu'il ne présente ni convergence ni divergence de plus de 5°, il parcourt un maximum du volume de la cellule à chaque passage. Sa section est de préférence sensiblement semblable à celle de la cellule (par exemple pour une cellule tubulaire de 1cm de diamètre, la section du faisceau est d'au moins 5 mm) ce qui permet à chaque passage de sonder une portion significative du gaz atomique et de là d'atteindre un gain significatif en termes de rapport signal-à-bruit.

Ces allers-retours s'opèrent ainsi au sein d'une cavité multi-passage qui, contrairement à d'autres types de cavités telles que des Fabry-Pérot, n'est pas résonante de sorte que son comportement est ainsi largement indépendant de la longueur d'onde de la lumière. Ceci est souhaitable pour rendre le magnétomètre robuste par exemple à des dérives lentes de longueur d'onde de la lumière telles que celles qui sont constatées sur de nombreux lasers commerciaux.

Comme c'est le cas en figure 1, le miroir 3 peut directement faire face au collimateur. Le miroir 3 peut être directement agencé sur une surface de la cellule. Le miroir 3 peut par exemple être déposé sur la surface de la cellule sous la forme d'un empilement de couches minces diélectriques ou d'un empilement mixte diélectrique/métal, ce qui permet de rendre le miroir et son positionnement parfaitement reproductible lorsque la cellule l'est également, par exemple car réalisée par des procédés de collage moléculaire.

Le miroir 3 est de préférence un miroir plan ou quasi-plan (par quasi-plan, on entendu que le rayon de courbure du miroir est au moins 20 fois, de préférence au moins 100 fois, supérieur au diamètre du miroir). Un tel miroir est effectivement peu épais (son épaisseur est par exemple de 0,5mm) et le gaz atomique qui constitue l'élément sensible peut alors être situé au plus proche du volume extérieur d'un compartiment de mesure dans lequel la cellule est agencée. Ceci est particulièrement intéressant pour des mesures biologiques, telles que celles réalisées en magnétoencéphalographie où ce miroir peut se situer quasiment au contact du cuir chevelu du patient de manière à ce que l'élément sensible se trouve à quelques millimètres seulement de la source des signaux corticaux à mesurer.

Comme représenté en figure 1, la cellule 1 peut effectivement être agencée dans un compartiment de mesure 5 d'une sonde 4 de mesure de champ magnétique. La sonde 4 comporte par ailleurs, empilé sur le compartiment de mesure, un compartiment optique 6 dans lequel est agencé le collimateur 2. Le compartiment optique 6 présente dans le plan ZX une section dont l'extension est similaire à celle du compartiment de mesure 5.

La sonde 4 présente ainsi une forme de parallélépipède droit s'étendant le long de l'axe Y et dispose d'une face supérieure formée par une surface supérieure du compartiment optique 6 où se situe une entrée optique 7 pour le faisceau de lumière et d'une face inférieure formée par une surface inférieure du compartiment de mesure 5 destinée à être en contact avec la source Sb de champ magnétique à mesurer.

Lorsque le faisceau optique délivré par la source optique est polarisé au moyen d'un polariseur rectiligne 8, ce dernier peut être agencé dans le compartiment optique 6.

Le faisceau de lumière peut être apporté depuis la source optique jusqu'à l'entrée optique 7 au moyen d'une fibre optique. La surface supérieure du compartiment optique 6 peut également disposer d'une sortie optique 9 pour le faisceau de lumière après son multi-passage à travers la cellule. Le collimateur 2 peut être exploité pour focaliser le faisceau de lumière en direction de la sortie optique, celle-ci étant optiquement couplée au détecteur, par exemple au moyen d'une fibre optique. Dans une variante, la sortie optique est confondue avec l'entrée optique. Dans une autre variante, le détecteur comprend une photodiode agencée dans le compartiment optique pour photo-détecter le faisceau de lumière après son multi-passage à travers la cellule.

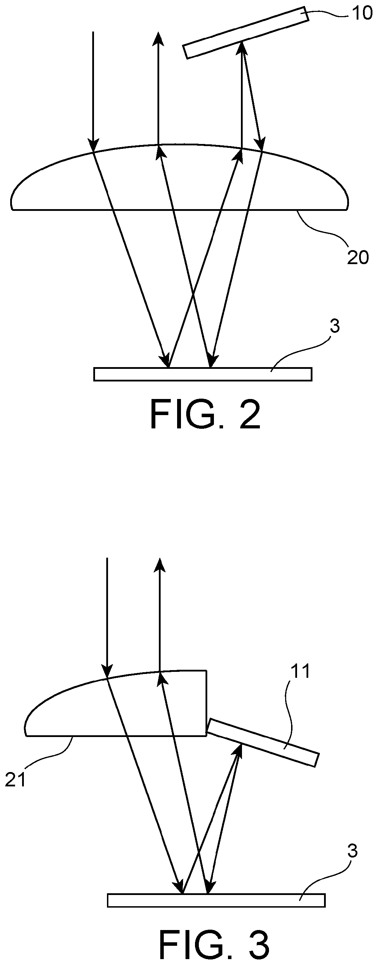

Le compartiment optique 6 peut également contenir différents éléments destinés à mettre en forme le faisceau de lumière et le réfléchir vers le miroir 3 à l'autre extrémité de la cellule dans le compartiment de mesure. Ces éléments peuvent comprendre des lentilles convergentes et des arrangements d'éléments réfléchissants disposés de telle façon que la lumière réalise un nombre fixe d'allers-retours dans la cellule. En référence aux figures 2 à 4, ces éléments peuvent notamment comprendre un ou plusieurs miroirs auxiliaires 10-13 sur lesquels le faisceau de lumière collimaté est incident et qui sont agencés dans le compartiment optique pour participer au multi-passage du faisceau de lumière collimaté à travers la cellule.

La sonde 4 peut être agencée côte-à-côte avec d'autres sondes similaires, par exemple pour former un réseau matriciel permettant de réaliser une mesure du champ magnétique bien résolue spatialement. Cet agencement peut être réalisé de manière compacte, sans perte de place pour assurer des fonctions optiques telles que l'acheminement de la lumière, sa polarisation ou sa photo-détection. Chaque sonde a pour objet de réaliser une mesure très bas bruit du champ magnétique sur le volume de son élément sensible, ce qui permet de remonter par des procédés de reconstruction de sources de champs aux sources de courants situées à proximité des sondes. Ces sources peuvent être par exemple des courants nerveux dans le cerveau, des courants liés au fonctionnement cardiaque, ou encore des courants provenant de l'induction par une source magnétique très basse fréquence dans une pièce métallique à caractériser. Dans tous les cas il est important que les éléments sensibles se situent au plus près de la source de champ, car celle-ci crée des champs magnétiques dont la décroissance varie en 1/d³ avec la distance d à leur source. L'invention permet d'obtenir un assemblage très dense des éléments sensibles tout en maintenant une distance minimale entre chacun d'entre eux et les sources de champ à caractériser.

Pour mesurer l'état d'alignement des atomes pompés avec une lumière en polarisation linéaire, que ce soit à l'aide d'une mesure d'absorption ou d'une mesure de changement d'ellipticité (changement de la proportion entre les polarisations circulaires de la lumière), on exploite un faisceau de sonde dont la polarisation linéaire doit idéalement rester toujours dans le même plan au cours de sa propagation (ce qui n'est pas le cas en orientation où le plan de polarisation de la lumière tourne sous l'effet de son interaction avec les atomes). Or la direction de propagation du faisceau de sonde change lors de la ou des réflexions subies au cours du multi-passage, de sorte que la direction de polarisation, orthogonale à celle de propagation, risque également de changer. Il peut en découler une dégradation de l'amplitude du signal, voire des effets indésirables tels que des déformations des courbes de résonance magnétique donnant lieu potentiellement à des décalages sur les mesures délivrées par le magnétomètre. Un tel changement de la direction de polarisation serait notamment observée sur la cavité de l'Université de Princeton devait être exploitée en alignement.

Ainsi dans un mode de réalisation de l'invention, tel que celui représenté en figure 1, le multi-passage est réalisé en conservant une direction de polarisation du faisceau de lumière invariante. Les inventeurs ont effectivement pu constater, autant par des modélisations théoriques que par des mesures expérimentales, qu'une amplitude du signal optimale peut être atteinte lorsque l'intégralité des trajectoires de propagation de la lumière à travers la cellule est contenue dans un seul et même plan, ce plan, en l'occurrence le plan XY, étant orthogonal à la polarisation linéaire qui ne varie donc pas.

Dans le cas où l'élément sensible est l'hélium-4, le magnétomètre comporte par ailleurs un système de décharge haute fréquence (HF), comprenant un générateur HF qui alimente via des fils 14 deux électrodes de décharge HF 15, pour amener les atomes du gaz atomique dans un état énergisé où ils sont aptes à subir une transition atomique, typiquement dans l'état métastable 2³S₁.

En variante, le miroir 3 du compartiment de mesure, voire également le cas échéant le ou les miroirs du compartiment optique, sont utilisés comme électrodes pour l'allumage de la décharge permettant de peupler l'état métastable 2³S₁. Ainsi il devient superflu d'ajouter une voire les deux électrodes 15 autour de la cellule.

Dans un mode de réalisation possible permettant de réaliser une mesure vectorielle du champ magnétique, le magnétomètre comprend également un circuit d'excitation de résonances paramétriques qui comporte un générateur de radiofréquence qui alimente des bobines d'Helmholtz d'axes orthogonaux qui, portées par un support 16, entourent la cellule afin de générer un champ magnétique d'excitation des résonances paramétriques, également désigné par champ radiofréquence d'excitation. Deux champs radiofréquences d'excitation sont typiquement appliqués à la cellule et les directions de ces champs, par exemple selon les axes X et Y, déterminent les directions principales de sensibilité du magnétomètre.

Le magnétomètre peut également comprendre un système d'asservissement en boucle fermé pour venir constamment soumettre la cellule à un champ magnétique total nul. Le système d'asservissement comprend un régulateur couplé à l'électronique de traitement qui injecte un courant dans les bobines de Helmholtz qui entourent la cellule 1 afin de générer un champ magnétique de compensation Bc tel que la somme Bc+B₀ est maintenue à zéro en permanence. Alternativement, le magnétomètre peut être opéré en boucle ouverte, sans compensation du champ ambiant.

Dans l'exemple de la figure 1, le faisceau de lumière est transporté depuis la source laser où il est généré jusqu'à chacune des sondes par une fibre optique. A l'extrémité de cette fibre le faisceau diverge avec un angle lié à l'ouverture numérique du type de fibre utilisé. Une lentille convergente disposé juste au-dessous permet de collimater cette lumière et d'en fixer le diamètre, par exemple à 6 mm. Cette lumière collimaté traverse l'élément sensible une première fois puis est réfléchie sur un miroir plan, qui la réfléchit de manière à ce qu'elle traverse une deuxième fois une même région de l'élément sensible. Dans cette configuration simple à deux passages, une fois sortie de la cellule, cette lumière passe de nouveau par la lentille convergente, ce qui a pour effet de la faire converger à l'intérieur d'une deuxième fibre optique destinée à l'acheminer jusqu'à un photo-détecteur situé à l'extérieur de la sonde.

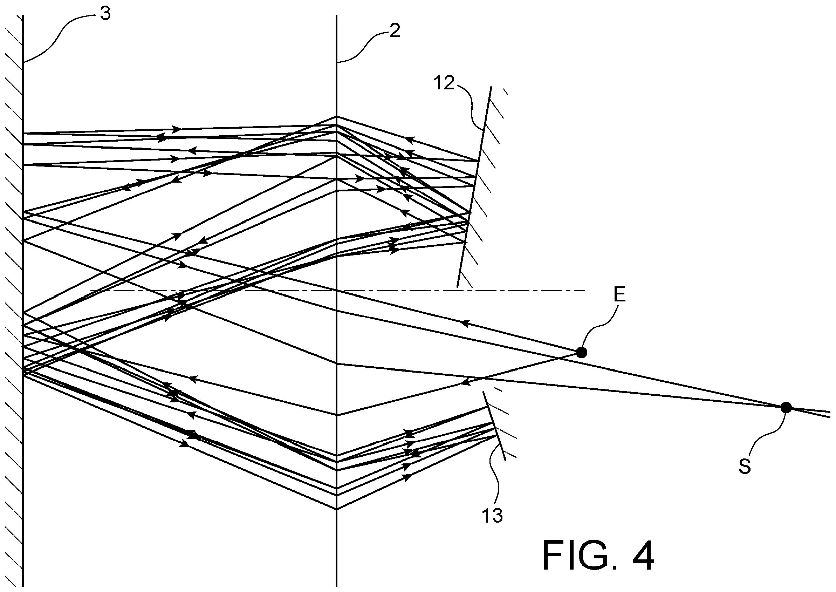

Des configurations plus complexes mais plus avantageuses peuvent parfaitement être réalisées comme cela est représenté en figures 3 et 4 où la lumière à l'issue de ce deuxième passage converge sur un deuxième miroir 10, 11 disposé de telle façon que le faisceau traverse une troisième puis, suite à une nouvelle réflexion sur le miroir 3 du compartiment de mesure, une quatrième fois la cellule avant d'être collecté dans la fibre retour ou directement photo-détecté.

Ce même principe peut être étendu à un nombre pair arbitraire de passages, ce nombre étant uniquement limité par la qualité des optiques et le volume nécessaire à les disposer dans le compartiment optique de la sonde. La figure 4 représente à cet égard une modélisation logicielle d'un exemple de configuration qui, outre le collimateur 2 et le miroir 3 du compartiment de mesure, exploite un deuxième et un troisième miroirs 12, 13 agencés dans le compartiment optique pour réaliser huit passages à travers la cellule depuis un point d'entrée E jusqu'à un point de sortie S.

## Revendications

1. Magnétomètre à pompage optique, comprenant une cellule (1) remplie d'un gaz atomique et un détecteur configuré pour délivrer un signal porteur d'une information relative à un état d'alignement des atomes du gaz atomique dans la cellule, comprenant en outre une source optique apte à délivrer un unique faisceau de lumière polarisé linéairement faisant à la fois office de pompe et de sonde, **caractérisé en ce qu'**il comprend un collimateur (2) agencé pour collimater l'unique faisceau de lumière avant qu'il n'éclaire la cellule et un miroir (3) agencé pour réfléchir l'unique faisceau de lumière collimaté après qu'il a traversé la cellule de sorte que l'unique faisceau de lumière collimaté réalise un multi-passage à travers la cellule en venant éclairer plusieurs fois une même région de la cellule.

2. Magnétomètre selon la revendication 1, dans lequel le miroir fait face au collimateur.

3. Magnétomètre selon l'une des revendications 1 et 2, dans lequel le miroir est agencé sur une surface de la cellule.

4. Magnétomètre selon l'une des revendications 1 à 3, dans lequel le miroir est un miroir plan.

5. Magnétomètre selon l'une des revendications 1 à 4, comprenant une sonde de mesure (4) qui comporte un compartiment de mesure (5) dans lequel est agencée la cellule (1) et, empilé sur le compartiment de mesure, un compartiment optique (6) dans lequel est agencé le collimateur (2).

6. Magnétomètre selon la revendication 5, dans lequel le compartiment optique dispose d'une entrée optique (7) pour l'unique faisceau de lumière et d'un polariseur linéaire (8) interposé entre l'entrée optique et le collimateur.

7. Magnétomètre selon l'une des revendications 5 et 6, dans lequel le comportement optique dispose d'une sortie optique (9) pour l'unique faisceau de lumière après le multi-passage à travers la cellule, la sortie optique étant optiquement couplée au détecteur.

8. Magnétomètre selon l'une des revendications 5 et 6, dans lequel le détecteur comprend une photodiode agencée dans le compartiment optique pour photo-détecter l'unique faisceau de lumière après le multi-passage à travers la cellule.

9. Magnétomètre selon l'une des revendications 5 à 8, dans lequel un ou plusieurs miroirs auxiliaires sur lesquels l'unique faisceau de lumière collimaté est incident sont agencés dans le compartiment optique pour participer au multi-passage de l'unique faisceau de lumière collimaté à travers la cellule.

10. Magnétomètre selon l'une des revendications 1 à 9, dans lequel une direction de polarisation de l'unique faisceau de lumière est invariante lors du multi-passage à travers la cellule.

11. Dispositif de magnétométrie comprenant une pluralité de magnétomètres selon l'une des revendications 1 à 10 agencés en réseau.

## Patentansprüche

1. Optisch gepumptes Magnetometer, das eine Zelle (1) umfasst, welche mit einem atomaren Gas gefüllt ist, und einen Detektor, der dazu ausgebildet ist, ein Signal zu liefern, das eine Information zu einem Ausrichtungszustand der Atome des atomaren Gases in der Zelle enthält, ferner umfassend eine optischen Quelle, die dazu in der Lage ist, einen einzelnen linear polarisierten Lichtstrahl zu liefern, der gleichzeitig als Pumpe und als Sonde dient, **dadurch gekennzeichnet, dass** es einen Kollimator (2) umfasst, der dazu angeordnet ist, den einzelnen Lichtstrahl zu kollimieren, bevor dieser die Zelle beleuchtet, und einen Spiegel (3), der dazu angeordnet ist, den einzelnen kollimierten Lichtstrahl zu reflektieren, nachdem er die Zelle durchlaufen hat, so dass der einzelne kollimierte Lichtstrahl die Zelle mehrfach durchläuft und einen gleichen Bereich der Zelle mehrfach beleuchtet.

2. Magnetometer nach Anspruch 1, wobei der Spiegel dem Kollimator zugewandt ist.

3. Magnetometer nach einem der Ansprüche 1 und 2, wobei der Spiegel auf einer Oberfläche der Zelle angeordnet ist.

4. Magnetometer nach einem der Ansprüche 1 bis 3, wobei der Spiegel ein Planspiegel ist.

5. Magnetometer nach einem der Ansprüche 1 bis 4, umfassend eine Messsonde (4), die ein Messfach (5) umfasst, in welchem die Zelle (1) angeordnet ist, und ein auf das Messfach gestapeltes optisches Fach (6), in welchem der Kollimator (2) angeordnet ist.

6. Magnetometer nach Anspruch 5, wobei das optische Fach einen optischen Eingang (7) für den einzelnen Lichtstrahl und einen linearen Polarisator (8) aufweist, der zwischen dem optischen Eingang und dem Kollimator angeordnet ist.

7. Magnetometer nach einem der Ansprüche 5 und 6, wobei das optische Fach einen optischen Ausgang (9) für den einzelnen Lichtstrahl nach dem mehrfachen Durchlaufen der Zelle umfasst, wobei der optische Ausgang optisch mit dem Detektor gekoppelt ist.

8. Magnetometer nach einem der Ansprüche 5 und 6, wobei der Detektor eine Fotodiode umfasst, die in dem optischen Fach angeordnet ist, um den einzelnen Lichtstrahl nach dem mehrfachen Durchlaufen der Zelle zu fotodetektieren.

9. Magnetometer nach einem der Ansprüche 5 bis 8, wobei ein oder mehrere Hilfsspiegel, auf die der einzelne kollimierte Lichtstrahl trifft, in dem optischen Fach angeordnet sind, um am mehrfachen Durchlaufen des einzelnen kollimierten Lichtstrahls durch die Zelle teilzunehmen.

10. Magnetometer nach einem der Ansprüche 1 bis 9, wobei eine Polarisationsrichtung des einzelnen Lichtstrahls während des mehrfachen Durchlaufens der Zelle invariant ist.

11. Magnetometrie-Vorrichtung, umfassend eine Vielzahl von Magnetometern nach einem der Ansprüche 1 bis 10, welche in einem Netzwerk angeordnet sind.

## Claims

1. Magnetometer with optical pumping, comprising a cell (1) filled with an atomic gas and a detector configured to output a signal carrying information about an alignment state of atoms of the atomic gas in the cell, further comprising an optical source able to output a single linearly polarised light beam used as pump and probe, **characterized in that** it comprises a collimator (2) arranged to collimate the single light beam before it illuminates the cell and a mirror (3) arranged to reflect the single collimated light beam after it has passed through the cell such that the single collimated light beam makes a multipass through the cell by illuminating the same region of the cell several times.

2. Magnetometer according to claim 1, wherein the mirror faces the collimator.

3. Magnetometer according to one of claims 1 and 2, wherein the mirror is arranged on a surface of the cell.

4. Magnetometer according to one of claims 1 to 3, wherein the mirror is a plane mirror.

5. Magnetometer according to one of claims 1 to 4, comprising a measurement probe (4) that contains a measurement compartment (5) inside which the cell (1) is located and, stacked on the measurement compartment, an optical compartment (6) inside which the collimator (2) is located.

6. Magnetometer according claim 5, wherein the optical compartment has an optical input (7) for the single light beam and a linear polariser (8) interposed between the optical input and the collimator.

7. Magnetometer according to one of claims 5 and 6, wherein the optical compartment has an optical output (9) for the single light beam after the multipass through the cell, the optical output being optically coupled to the detector.

8. Magnetometer according to one of claims 5 and 6, wherein the detector comprises a photodiode arranged in the optical compartment to photo-detect the single light beam after the multipass through the cell.

9. Magnetometer according to one of claims 5 to 8, wherein one or several auxiliary mirrors on which the single collimated light beam is incident are located in the optical compartment to participate in the multipass of the single collimated light beam through the cell.

10. Magnetometer according to one of claims 1 to 9, wherein a polarisation direction of the single light beam is constant during the multipass through the cell.

11. Magnetometry device comprising a plurality of magnetometers according to one of claims 1 to 10 arranged in a network.
